Europäisches Patentamt

European Patent Office

Office européen des brevets

(11) Veröffentlichungsnummer: **0 482 419 A1**

# EUROPÄISCHE PATENTANMELDUNG

(21) Anmeldenummer: **91117152.8**

(22) Anmeldetag: **08.10.91**

(51) Int. Cl.⁵: **H05K 5/06**, H05K 5/00

(30) Priorität: **25.10.90 DE 4033999**

(43) Veröffentlichungstag der Anmeldung:
**29.04.92 Patentblatt 92/18**

(84) Benannte Vertragsstaaten:
**DE FR GB IT**

(71) Anmelder: **SIEMENS AKTIENGESELLSCHAFT**
**Wittelsbacherplatz 2**
**W-8000 München 2(DE)**

(72) Erfinder: **Drekmeier, Karl Gerd**
**Bussardstrasse 42**
**W-8025 Unterhaching(DE)**

(54) Schaltungsmodul mit Sicherheitsgehäuse.

(57) Eine auf einer Trägerplatte (10) angeordnete Hybridschaltung (11) ist in einem Gehäuse (1) aus Keramik angeordnet und in Vergußmasse (14) eingebettet. Verschiedene konstruktive Maßnahmen (8, 15, 18, 19, 20) und die Wahl verschiedener Materialien in Vergußmassen (14, 16, 17) bzw. in Abdeckelementen (15, 18, 19, 20) sichern die Chips der Hybridschaltung gegen einen Eingriff mit chemischen oder physikalischen Mitteln.

FIG 1

EP 0 482 419 A1

Die Erfindung betrifft einen Schaltungsmodul mit einer auf einer Trägerplatte angeordneten Hybridschaltung, welche in einem Gehäuse angeordnet ist, welches mit einer Basisplatte und mit ringsum in Form eines U-Profils angeformten Seitenwänden eine Schaltungskammer umschließt, in der eine Trägerplatte mit der Hybridschaltung angeordnet und in eine die Schaltungskammer füllende Vergußmasse eingebettet ist.

Multichip-Schichtschaltungen auf Trägerplatten werden üblicherweise nur durch Umhüllung mit Epoxidharz gegen Umwelteinflüsse geschützt. Allenfalls wird der Schaltkreis in einem Kunststoffgehäuse verschlossen.

Eine derartige Schichtschaltung mit Umhüllung ist aus der DE-OS 35 22 091 bekannt. Dort ist neben der das Kunststoffgehäuse ausfüllenden, vergleichsweise elastischen Vergußmasse eine andere, vergleichsweise wenig elastische Isolierstoffschicht lediglich zur Überdeckung der Anschlußdrähte im Bereich der Kontaktflächen vorgesehen, welche vorzugsweise in ihrem thermischen Ausdehnungskoeffizienten an den der Schichtschaltung angepaßt ist.

Aus der DE-OS 30 36 371 ist ebenfalls eine Hybridschaltungspackung mit einem Kunststoffgehäuse bekannt, wobei eine Schaltungsplatte auf einer Gehäusestufe gehalten ist. Die Schaltungsplatte ist mehr oder weniger mit Einbettungsmaterial umhüllt und in dem Gehäuse dicht verschlossen. In diesem wie in dem vorhergehenden Fall könnte die Schichtschaltung verhältnismäßig einfach und ohne Zerstörung aus dem Gehäuse entnommen werden.

Aus der DE-OS 33 18 289 ist ein Gehäuse zur Kapselung einer Halbleiter-Hochspannungsschaltanordnung bekannt, welches in mehreren Teilen aus Keramikmaterial mit Glasabdichtungen besteht, so daß ein dichter keramischer Hohlraum gebildet wird, durch den als einzige metallische Teile die Anschlußverbindungen zur Halbleiter-Schaltanordnung führen. Zur Aufnahme einer Schichtschaltung ist dieses Gehäuse nicht vorgesehen; insbesondere wäre die Schichtschaltung bei Zerstörung des Keramikgehäuses ohne weiteres zugänglich.

Die DE-OS 33 15 230 beschreibt schließlich ein Aluminium-Filtergehäuse mit kreiszylindrischem Querschnitt, welches eine Vergußmasse, beispielsweise Epoxidharz, aufnehmen soll. Um dabei die Haftfähigkeit der Vergußmasse an der Gehäuse-Innenwand zu erhöhen und gleichzeitig das Wärmeableitvermögen des Gehäuses zu verbessern, sind parallel zur Gehäusemantellinie hinterschnittene Rippen an der Gehäuseinnenwand vorgesehen. Zur Aufnahme einer Hybridschaltung ist dieses Gehäuse ebenfalls nicht geeignet.

Es gibt jedoch Anwendungsfälle, bei denen Schlüsselbausteine in Hybridtechnik nicht nur gegen Umwelteinflüsse, sondern auch gegen unbefugten Eingriff geschützt werden müssen. Beispielsweise enthalten solche Hybridschaltungen bzw. in der Hybridschaltung integrierte Speicherbausteine Informationen und Codierungen, die gegen ein datentechnisches Auslesen geschützt werden müssen.

Aufgabe der Erfindung ist es, einen Schaltungsmodul der eingangs genannten Art in dem Gehäuse derart geschützt unterzubringen, daß die Hybridschaltung auch mit ausgeklügelten chemischen und physikalischen Methoden nicht zerstörungsfrei freigelegt und der in ihr gespeicherten Informationen beraubt werden kann.

Erfindungsgemäß wird diese Aufgabe bei einem Schaltungsmodul der eingangs genannten Art dadurch gelöst, daß das Gehäuse aus Keramik besteht und im Bereich der Schaltungskammer Halteelemente für die Trägerplatte der Hybridschaltung aufweist, daß in der Schaltungskammer parallel zur Trägerplatte und der Basisplatte bezüglich des Schaltungsmoduls gegenüberliegend mindestens eine Abdeckplatte aus Keramik angeordnet und mit in die Vergußmasse eingebettet ist, daß ferner in dem Gehäuse im Bereich oberhalb und/oder unterhalb der Hybridschaltung zu dieser annähernd parallel liegend eine oder mehrere plattenförmige Einlagen aus Metall eingebettet sind und daß die Vergußmasse bezüglich Wärmeausdehnungseigenschaften und Festigkeit an die Hybridschaltung angepaßt ist.

Der erfindungsgemäße Schaltungsmodul besitzt somit ein Gehäuse, das zusammen mit der Abdeckplatte die Hybridschaltung nach allen Seiten mit Keramikwänden umschließt, so daß sie nicht mehr ohne weiteres aus dem Gehäuse entfernt werden kann. Die Metalleinlage gibt zusätzlich eine Sicherung gegen zerstörungsfreies Abschleifen der Hybridschaltung.

In der Regel wird das die Schaltungskammer bildende U-Profil mit seiner Öffnung nach unten zur Anschlußseite der Hybridschaltung zeigen, so daß die Schichtschaltung und die integrierten Bausteine, insbesondere Speicherchips, auf der Oberseite der Trägerplatte zwischen dieser und der Basisplatte des Gehäuses eingeschlossen sind, während die Anschlußfahnen an den Seiten der Trägerplatte nach unten herausgeführt sind. Zusammen mit der Trägerplatte ergibt sich somit eine zusätzliche Abdeckung des Schaltungsmoduls mit Keramikwänden. Selbst bei einem Angriff mit sehr aggressiven chemischen Lösungsmitteln zur Entfernung der Vergußmasse besteht die Wahrscheinlichkeit, daß die Schaltung selbst mit zerstört wird, da der Zugang des Lösungsmittels in den Raum innerhalb der Trägerplatte stark gehindert wird. Beim Trokkenschleifen des Gehäuses zur Freilegung der Hybridschaltung dagegen besteht, insbesondere durch die erwähnte Metalleinlage, die Wahrscheinlichkeit, daß die Schaltung dabei selbst angegriffen und zerstört wird.

Ist die Schaltungskammer nach unten offen und sind die Anschlußelemente zur Unterseite herausgeführt, so werden zweckmäßigerweise drei Abdeckplatten in einer Ebene so angeordnet, daß zwischen ihnen ein Spalt für die Anschlußelemente freibleibt. Denkbar wäre es allerdings auch, die Basisplatte als Boden der dann nach oben offenen Schaltungskammer zu verwenden; in diesem Fall müßten in der Basisplatte Spalte für die Durchführung der Anschlußelemente freigehalten sein. Die Oberseite der Schaltungskammer würde man dann zweckmäßigerweise mit einer durchgehenden Abdeckplatte in der Vergußmasse verschließen.

Die Durchführungen für die Anschlußstifte in der Abdeckplatte oder gegebenenfalls in der Basisplatte können als gemeinsame Spalte oder auch als Einzeldurchbrüche für die Anschlußstifte vorgesehen sein. Weiterhin ist es zweckmäßig, die Abdeckplatte in den Randbereichen mit verhältnismäßig geringer Dicke zu gestalten, während sie im Mittelbereich, also im Bereich unterhalb der Hybridschaltung selbst, eine vergleichsweise große Dicke haben sollte. Dadurch erreicht man, daß die Schichtschaltung gut geschützt wird, daß aber andererseits die Abdeckplatte beim Angriff mit Werkzeugen am Randbereich abbricht. Aushebelkräfte werden also nicht übertragen, und die Abdeckplatte kann auf diese Weise nicht mechanisch aus dem Gehäuse gehoben werden.

Um ein mechanisches Herauslösen der Vergußmasse aus der Schaltungskammer zu verhindern, sind die Seitenwände der Schaltungskammer zweckmäßigerweise mit Hinterschneidungen bzw. Vorsprüngen versehen, so daß sie einen Formschluß mit dem erstarrten Gießharzkörper bilden. In einer zweckmäßigen Ausgestaltung sind dabei die Innenseiten prismatisch ausgeformt. Der neben dem Schaltungsmodul in der Schaltungskammer freibleibende Raum wird zweckmäßigerweise durch Trennstege unterteilt, die an den Seitenwänden angeformt oder befestigt sind. Diese Trennstege können auch Auflageschultern für die Trägerplatte bzw. die Abdeckplatten aufweisen.

In einer zweckmäßigen Ausgestaltung weist das Gehäuse auch an der der Schaltungskammer gegenüberliegenden Seite der Basisplatte eine von angeformten Seitenwänden ringsum umschlossene, mit Vergußmasse gefüllte Kaverne auf. Die Vergußmassen in der Schaltungskammer und in der zusätzlichen Kaverne können über Löcher in der Basisplatte miteinander nietenartig verbunden und so gegen mechanisches Herauslösen gesichert sein. Die Vergußmasse in der Kaverne, vorzugsweise ein schwer lösliches Gießharz, wird zweckmäßigerweise zumindest im unteren Bereich mit Graphitpartikeln bzw. Graphitkugeln gefüllt. Diese Graphitpartikel sind elektrisch leitfähig und stark schmierend, so daß beim Anschleifen Verunreinigungen auf der Schliffoberfläche entstehen, die eine Auswertung der freigelegten Schaltung verhindern.

Wie erwähnt, wird eine weitere Sicherung der Hybridschaltung gegen unbefugten Zugriff durch die plattenförmigen Einlagen aus Metall gewährleistet. Diese können frei eingebettet oder in Nuten der Basisplatte eingelegt sein. Zweckmäßigerweise werden Einlagen aus verschiedenen Metallen verwendet, beispielsweise aus technisch reinem Kupfer (E-Cu), aus Magnesium und aus gehärtetem Stahl. Hierdurch wird erreicht, daß das Annähern an die Chips in der Schaltung durch abrasive Prozesse, wie Schleifen, Fräsen, Bohren und dergl. zur Zerstörung definierter Kontaktstellen an den Chips oder den Zuleitungen führt. Dabei werden folgende Effekte genutzt:

a) Beim Schleifen mit Wasserkühlung entsteht an einer Einlage aus Magnesium eine stark ätzende Lauge $Mg(Oh)_2$ unter Freisetzung von $H_2$. Diese Lauge zerstört die Aluminiumkontakte der Chips.

b) Das freigesetzte $H_2$ reagiert mit $O_2$ zu Knallgas.

c) Die Reaktionen von a) und b) sind stark exotherm und wirken zerstörend auf die Umgebung, d. h. auf die Schlifffläche.

d) Die Stahlplatte bewirkt hohe Temperaturen sowie Funkenflug beim Trockenschleifen; dabei werden angeschliffene Kontaktstellen angegriffen.

e) Bei Einlagen aus E-Cu und Mg verschmieren diese Materialien leitend die Schlifffläche und behindern dadurch ein definiertes Kontaktieren der eng gerasteten Chip-Anschlüsse.

f) Ein mechanisches Freilegen der Schaltung würde wegen des äußerst spröden Materials des Gehäuses und der Trägerplatten, beispielsweise $Al_2O$, zu Brüchen in dem Gesamtaufbau führen und die Schaltung zerstören.

Die Erfindung wird nachfolgend an einem Ausführungsbeispiel anhand der Zeichnung näher erläutert. Es zeigen

Figur 1 einen erfindungsgemäßen Schaltungsmodul mit Gehäuse in perspektivischer Darstellung, jedoch geschnitten,

Figur 2 einen Ausschnitt aus dem Gehäuse von Figur 1 im Zustand vor dem Vergießen.

Figur 3 ein gegenüber Figur 1 abgewandeltes Ausführungsbeispiel.

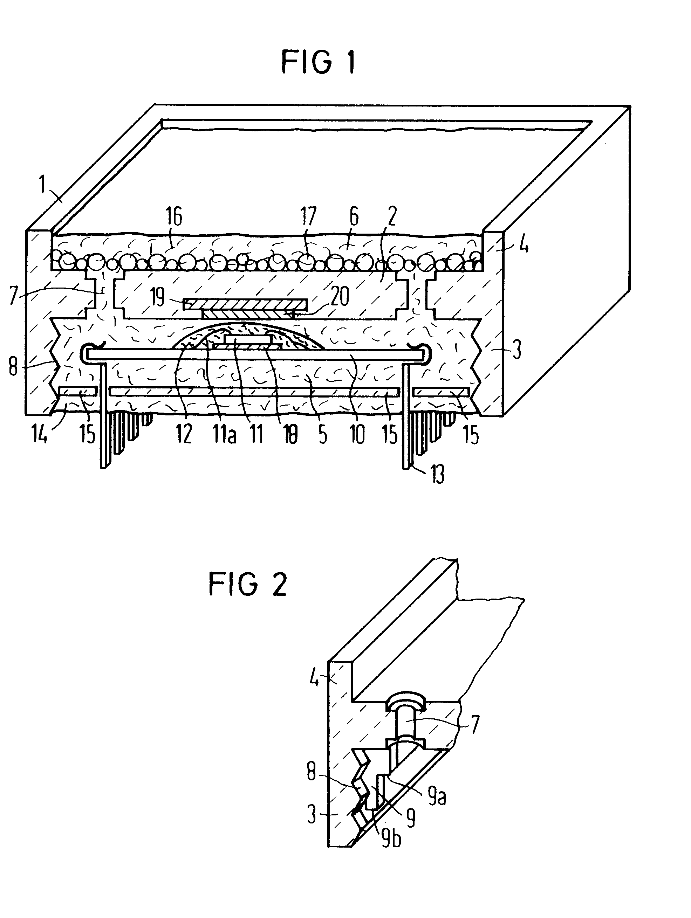

Das in der Zeichnung dargestellte Gehäuse 1 besteht aus Keramikmaterial, beispielsweise $Al_2O_3$ Es wird gebildet von einer zentralen Basisplatte 2, an der nach unten umlaufende Seitenwände 3 und nach oben ebenfalls umlaufende Seitenwände 4 angeformt sind, so daß sich sowohl nach unten als auch nach oben jeweils ein U-Profil bzw. insgesamt ein H-Profil ergibt. Dadurch bildet das Gehäuse eine nach unten offene Schaltungskammer 5 und eine nach oben offene Kaverne 6, welche über Löcher 7 in der Basisplatte 2 miteinander verbunden sind. Die Seitenwände der Schaltungskammer 5 sind mit umlaufenden Rippen oder Vorsprüngen 8 versehen und bilden somit nach innen eine prismatisch ausgebildete Oberfläche. Außerdem sind von den Seitenwänden her nach innen vorstehende Trennstege 9 angeformt, welche eine Gliederung der Randbereiche der Schaltungskammer bilden. Durch eine abgestufte Ausbildung dieser Trennstege 9 werden Auflageschultern 9a und 9b für eine Trägerplatte 10 bzw. später noch zu beschreibende Abdeckplatten gebildet. In der Schaltungskammer 5 ist die Trägerplatte 10 angeordnet und über die Auflageschultern 9a der Trennstege parallel zu der Basisplatte 2 gehalten. Die Trägerplatte, die beispielsweise ebenfalls aus Keramik besteht, ist Bestandteil einer Hybridschaltung mit üblichem Aufbau. Sie kann beispielsweise integrierte Leiterbahnen und Widerstände sowie diskrete Chips, etwa einen Rechnerbaustein (CPU), einen Speicherbaustein (RAM), einen programmierbaren Speicherbaustein (EEPROM) und einen ASIC enthalten. In Figur 1 ist lediglich als Beispiel ein Chip 11 mit entsprechenden Anschlußbeinen 11a gezeigt. Die Chips sind mit einem Epoxidtropfen 12 in üblicher Weise gegen Umwelteinflüsse geschützt. An der Trägerplatte 10 sind die Anschlüsse 13 der Schaltung in zwei Reihen nach unten herausgeführt.

Zum Schutz der Hybridschaltung gegen unbefugten Zugriff ist die Schaltungskammer 5 mit Vergußmasse 14 gefüllt, welche ein mit Quarzmehl hochgefülltes Epoxidharz ist. Dieses Gießharz ist nur mit sehr aggressiven Lösungsmitteln bei guter Zugänglichkeit lösbar. Durch die prismatische Struktur der Seitenwände 3 und den dadurch gewonnenen Formschluß ist ein mechanisches Herauslösen der Vergußmasse 14 nicht möglich. Außerdem ist der Zugang mit Lösungsmitteln durch Abdeckplatten 15, die zwischen den Anschlußelementen 13 und neben diesen angeordnet sind, stark gehindert. Diese Platten 15 bestehen aus Keramikmaterial und können deshalb ebenso wenig wie das Gehäuse selbst von Lösungsmitteln angegriffen werden. Sie liegen am Rand jeweils auf den Schultern 9b der Stege 9 auf.

Die obere Gehäusekaverne 6 ist ebenfalls mit einem chemisch schwer lösbaren Gießharz 16 gefüllt, welches über die Löcher 7 mit dem Gießharz 14 der Schaltungskammer in Verbindung steht und dadurch nietenartig gehalten wird. Der untere Bereich der Füllung der Vergußmasse 16 besteht aus elektrisch leitfähigen und stark schmierenden Graphitkugeln 17, welche beim Abschleifen die Schleifoberfläche verunreinigen würden.

Unterhalb der Chips 11 ist eine Einlage in Form einer Kupferplatte 18 angeordnet; außerdem sind oberhalb der Hybridschaltung weitere Einlagen in Form einer gehärteten Stahlplatte 19 und einer Magnesiumplatte 20 in Nuten der Basisplatte angeordnet. Mit diesen Metallplatten werden beim Schleifen die oben erwähnten Effekte ausgelöst, die den Zugang zu den gespeicherten Informationen unmöglich machen.

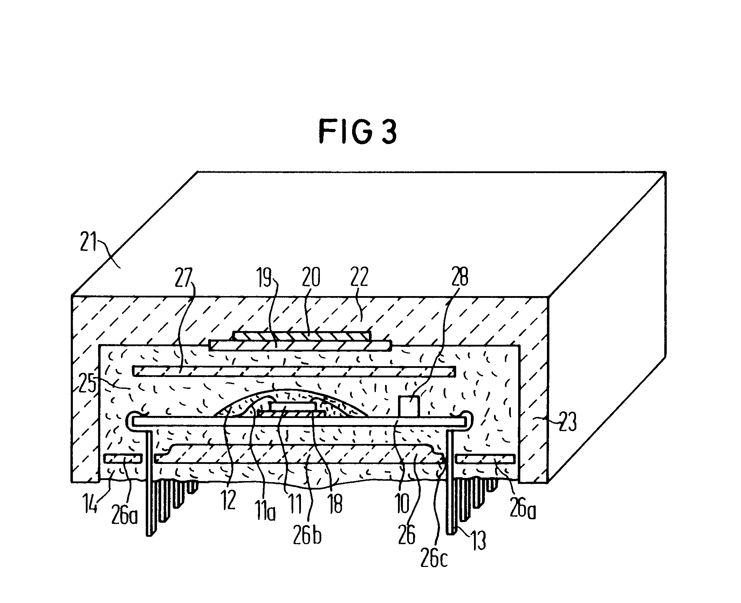

In Figur 3 ist eine abgewandelte Ausführungsform des erfindungsgemäßen Schaltungsmoduls gezeigt. In diesem Fall ist ein etwas vereinfachtes Gehäuse 21, das aus einer Basisplatte 22 sowie nach unten umlaufenden Seitenwänden 23 besteht. Dadurch bildet das Gehäuse eine nach unten offene Schaltungskammer 25, jedoch keine oberseitige Kaverne wie im vorhergehenden Beispiel. Bedarfsweise könnten die Seitenwände wie im vorhergehenden Beispiel auch mit Rippen oder Vorsprüngen versehen sein. Zweckmäßigerweise sind die nicht dargestellten Trennstege 9 mit den Auflageschultern 9a und 9b wie in Figur 2 hier ebenfalls vorgesehen. Die Trägerplatte 10 mit der Hybridschaltung ist wie in Figur 1 aufgebaut, so daß hierzu eine gesonderte Beschreibung nicht erforderlich ist. Auf der Trägerplatte ist zusätzlich ein Bauelement 28 gezeigt, das nicht mit dem Gießharz 12 ummantelt ist und somit beim Vergießen des Gehäuses ungeschützt bleibt. Wie im vorhergehenden Beispiel ist die Schaltungskammer 25 mit Vergußmasse 14 gefüllt. Diese Vergußmasse wird so gewählt, daß sie möglichst hart wird und durch Lösungsmittel möglichst wenig angegriffen werden kann, zugleich aber im Temperaturgang dem Keramikmaterial des Gehäuses und der Hybridschaltung angepaßt ist. Die Unterseite der Schaltungskammer 25 ist durch eine einteilige Abdeckplatte 26 aus Strukturkeramik abgedeckt, welche über die Anschlußstifte 13 gesteckt und in die Vergußmasse 14 eingebettet ist. Diese Abdeckplatte 26 besitzt in den Randbereichen 26a eine geringere Dicke als in dem Mittelbereich 26b unterhalb der Schichtschaltung. Dadurch kann der Randbereich 26a keine größeren Hebelkräfte übertragen, er würde also bei einer Manipulation mit Aushebelwerkzeugen abbrechen, ohne daß die Schichtschaltung aus dem Gehäuse entfernt werden kann. Der Mittelbereich 26b dagegen schützt durch seine größere Dicke zusätzlich die Schichtschaltung gegen einen Angriff von außen. Für den Durchtritt der Anschlußstifte 13 besitzt die Abdeckplatte 26 entweder längere Schlitze für mehrere Anschlußstifte oder, in bevorzugter Ausführungsform, Einzeldurchbrüche 26c für jeden der Anschlußstifte 13.

Zusätzlich ist in dem Beispiel von Figur 3 eine Keramikplatte 27 zwischen der Schichtschaltung und der Basisplatte 22 eingefügt, die lose in der Vergußmasse eingebettet ist. Ähnlich einer Armierung schützt diese Keramikplatte 27 ebenso wie die Abdeckplatte 26 beim Vergießen des Gehäuses die Schichtschaltung mechanisch vor den schädigenden, dreidimensional am Schaltungssubstrat angreifenden Gießharzkräften bei einem Temperaturgang von etwa 200 K. Zusätzlich werden auch ungeschützte Bauelemente 28 zu den Metalleinlagen 19 und 20 hin zuverlässig isoliert.

Das Gehäuse besteht in bevorzugter Ausführungsform ebenso wie die eingelegten Platten 26 und 27 aus einer Strukturkeramik, wobei als Material bevorzugt Aluminiumoxid ($Al_2O_3$) mit einem Reinheitsgrad von mindestens 96 %, vorzugsweise 98 %, verwendet wird. Durch diesen hohen Reinheitsgrad erhält man eine große Härte des Gehäuses. Im übrigen sei noch darauf hingewiesen, daß einzelne Merkmale der verschiedenen Ausführungsformen auch in anderer Weise beliebig kombiniert werden können.

**Patentansprüche**

1. Schaltungsmodul mit einer auf einer Trägerplatte (10) angeordneten Hybridschaltung (11), welche in einem Gehäuse (1; 21) angeordnet ist, welches (1; 21) mit einer Basisplatte (2; 22) und mit ringsum in Form eines U-Profils angeformten Seitenwänden (3; 23) eine Schaltungskammer (5; 25) umschließt, in der eine Trägerplatte (10) mit der Hybridschaltung (11) angeordnet und in eine die Schaltungskammer (5; 25) füllende Vergußmasse (14) eingebettet ist, **dadurch gekennzeichnet,** daß das Gehäuse (1; 21) aus Keramik besteht und im Bereich der Schaltungskammer (5; 25) Halteelemente (9) für die Trägerplatte (10) der Hybridschaltung (11) aufweist,
daß in der Schaltungskammer (5; 25) parallel zur Trägerplatte (10) und der Basisplatte (2; 22) bezüglich des Schaltungsmoduls gegenüberliegend mindestens eine Abdeckplatte (15; 26) aus Keramik angeordnet und mit in die Vergußmasse eingebettet ist,
daß ferner in dem Gehäuse (1; 21) im Bereich oberhalb und/oder unterhalb der Hybridschaltung (11) zu dieser annähernd parallel liegend eine oder mehrere plattenförmige Einlagen (18, 19, 20) aus Metall eingebettet sind und daß die Vergußmasse bezüglich Wärmeausdehnungseigenschaften und Festigkeit an die Hybridschaltung angepaßt ist.

2. Schaltungsmodul nach Anspruch 1, **dadurch gekennzeichnet,** daß das Gehäuse (1; 21) aus Aluminiumoxid, vorzugsweise mit einem Reinheitsgrad von mindestens 96 %, besteht.

3. Schaltungsmodul nach Anspruch 1 oder 2, **dadurch gekennzeichnet,** daß die Vergußmasse (14) mit anorganischem Füllstoff, z. B. Quarzmehl, hochgefülltes Gießharz ist.

4. Schaltungsmodul nach einem der Ansprüche 1 bis 3, **dadurch gekennzeichnet,** daß die Abdeckplatte (26) einen Randbereich (26a) geringerer Dicke und einen Mittelbereich (26b) größerer Dicke aufweist.

5. Schaltungsmodul nach einem der Ansprüche 1 bis 4, **dadurch gekennzeichnet,** daß die Seitenwände (3) der Schaltungskammer durch Hinterschneidungen bzw. Vorsprünge (8) einen Formschluß mit der Vergußmasse (14) bilden.

6. Schaltungsmodul nach einem der Ansprüche 1 bis 5, **dadurch gekennzeichnet,** daß die Seitenwände (3; 23) der Schaltungskammer (5; 25) senkrecht zu der Basisplatte (2; 22) stehende, die Schaltungskammer (5; 25) bis in den Bereich der Trägerplatte (10) unterteilende Trennstege (9) aufweisen.

7. Schaltungsmodul nach Anspruch 6, **dadurch gekennzeichnet,** daß die Trennstege (9) jeweils Auflageschultern (9a, 9b) für die Trägerplatte (10) und/oder die Abdeckplatte(n) (15; 26) aufweisen.

8. Schaltungsmodul nach einem der Ansprüche 1 bis 7, **dadurch gekennzeichnet,** daß das Gehäuse (1) an der der Schaltungskammer (5) gegenüberliegenden Seite der Basisplatte (2) eine von angeformten Seitenwänden (4) ringsum umschlossene, mit Vergußmasse (16) gefüllte Kaverne (6) aufweist.

9. Schaltungsmodul nach Anspruch 8, **dadurch gekennzeichnet,** daß die Vergußmassen (14, 16) in der Schaltungskammer (5) und in der Kaverne (6) über Löcher (7) in der Basisplatte miteinander nietenartig verbunden sind.

10. Schaltungsmodul nach Anspruch 8 oder 9, **dadurch gekennzeichnet,** daß im Bodenbereich der Kaverne (6) Graphitpartikel (17) in die Vergußmasse (16) eingelagert sind.

11. Schaltungsmodul nach einem der Ansprüche 1 bis 10, **dadurch gekennzeichnet,** daß eine oder mehrere der Metalleinlagen (19, 20) in Nuten der Basisplatte (2; 22) angeordnet sind.

12. Schaltungsmodul nach einem der Ansprüche 1 bis 10, **dadurch gekennzeichnet,** daß mindestens eine Metalleinlage (18) zwischen der Trägerplatte (10) und auf ihr angeordneten integrierten Schaltkreisen (11) angeordnet ist.

13. Schaltungsmodul nach einem der Ansprüche 1 bis 12, **dadurch gekennzeichnet,** daß zumindest eine der Metalleinlagen (19) aus E-Cu besteht.

14. Schaltungsmodul nach einem der Ansprüche 1 bis 13, **dadurch gekennzeichnet,** daß mindestens eine der Metalleinlagen (20) aus Magnesium besteht.

15. Schaltungsmodul nach einem der Ansprüche 1 bis 14, **dadurch gekennzeichnet,** daß mindestens eine der Metalleinlagen aus gehärtetem Stahl besteht.

16. Schaltungsmodul nach einem der Ansprüche 1 bis 15, **dadurch gekennzeichnet,** daß zwischen der Basisplatte (22) und der Hybridschaltung (11) eine Keramikplatte (27) annähernd parallel zur Basisplatte (22) in die Vergußmasse (14) eingebettet ist.

# FIG 1

# FIG 2

# FIG 3

Europäisches
Patentamt

EUROPÄISCHER
RECHERCHENBERICHT

Nummer der Anmeldung

EP 91 11 7152

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | FR-A-2 410 416   (BOSCH)<br>* Figuren 1,2; Seite 3, Zeile 1 - Seite 5, Zeile 39 *<br>– – – | 1,3,5-7 | H 05 K 5/06<br>H 05 K 5/00 |
| A | FR-A-2 506 112   (PLESSEY)<br>* Figuren 1-6; Seite 3, Zeile 25 - Seite 6, Zeile 5 *<br>– – – | 1,3,5-7,<br>12 | |
| A | US-A-4 443 655   (VAN DYK SOEREWYN)<br>* Figuren 1-7; Spalte, Zeile 39 - Spalte 4, Zeile 23 *<br>– – – | 1,3,5 | |
| A,D | DE-A-3 522 091   (SIEMENS)<br>* das ganze Dokument *<br>– – – | 1,3 | |
| A,D | GB-A-2 060 268   (HYBRID SYSTEMS)<br>* Figuren 1-6; Seite 1, Zeile 122 - Seite 2, Zeile 80 *<br>– – – – – | 1,6,7 | |

RECHERCHIERTE
SACHGEBIETE (Int. Cl.5)

H 05 K 5/00

Der vorliegende Recherchenbericht wurde für alle Patentansprüche erstellt

| Recherchenort | Abschlußdatum der Recherche | Prüfer |
|---|---|---|
| Berlin | 29 Januar 92 | HAHN G |